# EUROPÄISCHE PATENTSCHRIFT

(11) **EP 1 219 028 B1**
(45) Veröffentlichungstag und Bekanntmachung des Hinweises auf die Patenterteilung: **01.06.2005**
(21) Anmeldenummer: 00964249.7
(22) Anmeldetag: 28.09.2000
(51) Int. Cl.: H03H 3/02

(54) **AKUSTISCHER SPIEGEL UND VERFAHREN ZU DESSEN HERSTELLUNG**
ACOUSTIC MIRROR AND METHOD FOR THE PRODUCTION THEREOF
MIROIR ACOUSTIQUE ET SON PROCEDE DE FABRICATION

(30) Priorität: 30.09.1999 DE 19947081
(43) Veröffentlichungstag der Anmeldung: 03.07.2002
(73) Patentinhaber: Infineon Technologies AG, 81669 München (DE)
(72) Erfinder: AIGNER, Robert, 81675 München (DE); ELBRECHT, Lüder, 80805 München (DE); MARKSTEINER, Stephan, D-81739 München (DE); SÄNGER, Annette, 81667 München (DE); TIMME, Hans-Jörg, 85521 Ottobrunn (DE)
(74) Vertreter: Zimmermann & Partner
(86) Internationale Anmeldenummer: PCT/EP2000/009521
(87) Internationale Veröffentlichungsnummer: WO 2001/024361

(56) Entgegenhaltungen:
- US-A- 5 821 833
- DUBOIS M -A ET AL: "Solidly mounted resonator based on aluminum nitride thin film" , 1998 IEEE ULTRASONICS SYMPOSIUM. PROCEEDINGS (CAT. NO. 98CH36102), 1998 IEEE ULTRASONICS SYMPOSIUM. PROCEEDINGS, SENDAI, JAPAN, 5-8 OCT. 1998 , 1998, PISCATAWAY, NJ, USA, IEEE, USA, PAGE(S) 909 - 912 VOL.1 XP002154875 ISBN: 0-7803-4095-7 Seite 909, Spalte 1, Zeile 27 -Spalte 2, Zeile 2; Abbildung 1 Seite 910, Spalte 2, Zeile 1 - Zeile 25
- OLUTADE B L ET AL: "SENSITIVITY ANALYSIS OF A THIN FILM BULK ACOUSTIC RESONATOR LADDER FILTER" IEEE INTERNATIONAL FREQUENCY CONTROL SYMPOSIUM,US,NEW YORK, NY: IEEE, 28. Mai 1997 (1997-05-28), Seiten 737-742, XP000849589 ISBN: 0-7803-3729-8 in der Anmeldung erwähnt
- LAKIN K M ET AL: "DEVELOPMENT OF MINIATURE FILTERS FOR WIRELESS APPLICATIONS" IEEE MTT-S INTERNATIONAL MICROWAVE SYMPOSIUM DIGEST,US,NEW YORK, IEEE, 16. Mai 1995 (1995-05-16), Seiten 883-886, XP000536995 ISBN: 0-7803-2582-6
- YOSHIHIRO HAYASHI ET AL: "NITRIDE MASKED POLISHING (NMP) TECHNIQUE FOR SURFACE PLANARIZATION OF INTERLAYER-DIELECTRIC FILMS" INTERNATIONAL CONFERENCE ON SOLID STATE DEVICES AND MATERIALS,JA,JAPAN SOCIETY OF APPLIED PHYSICS. TOKYO, 1. August 1992 (1992-08-01), Seiten 533-535, XP000312264 in der Anmeldung erwähnt

## Beschreibung

Die Erfindung betrifft einen akustischen Spiegel, der akustische Wellen eines definierten Frequenzbereichs reflektiert.

Ein solcher akustischer Spiegel wird beispielsweise in B. Olutade et al, "Sensitivity Analysis of Thin Film Bulk Acoustic Resonator Ladder Filter", IEEE International Frequency Control Symposium 1997, 737, beschrieben. Der akustische Spiegel besteht aus einem Stapel von Dünnschichten mit abwechselnd hoher und niedriger akustischer Impedanz. Die Dicke der Dünnschichten beträgt beispielsweise ein Viertel der Wellenlänge der zu reflektierenden akustischen Wellen in der jeweiligen Dünnschicht. Vorzugsweise ist die Herstellung des akustischen Spiegels möglichst kompatibel zu Silizium-Prozeßtechniken, damit der akustische Spiegel zusammen mit anderen Bauelementen auf einem Chip integriert werden können.

Aus Y. Hayashi et al., "Nitride Masked Polishing (NMP) Technique for Surface Planarization of Interlayer-Dielectric Films", Ext. Abstr. of the 1992 Int. Conf. on Solid State Devices and Materials, Tsukuba (1992) 533 ist bekannt, zum Erzeugen einer möglichst planaren Oberfläche einer Schicht aus Borphosphorsilikatglas (BPSG), die ein erhöhtes Zellenfeld und eine Peripherie einer Speicherzellenanordnung bedeckt, eine Stopschicht aus Siliziumnitrid auf einen Teil der Schicht aus BPSG oberhalb der Peripherie aufzubringen und anschließend chemisch-mechanisch zu planarisieren. Vor der Planarisierung ist ein Teil der Schicht aus BPSG oberhalb des Zellenfeldes erhöht. Dieser Teil wird aufgrund der Stopschicht selektiv zum Teil der Schicht aus BPSG oberhalb der Peripherie beim Planarisieren entfernt.

Ein weiterer derartiger ahnslischer Spiegel ist aus US-A-5 821 833 bekannt.

Der Erfindung liegt das Problem zugrunde, einen akustischen Spiegel anzugeben, dessen Herstellung kompatibel zu Silizium-Prozeßtechniken ist und der im Vergleich zum Stand der Technik eine besonders hohe Reflektivität aufweisen kann. Ferner soll ein Verfahren zur Herstellung eines solchen akustischen Spiegels angegeben werden.

Das Problem wird gelöst durch einen akustischen Spiegel gemäß Anspruch 1 und ein Verfahren zur Herstellung eines akustischen Spiegels gemäß Anspruch 7.

Weitere Ausgestaltungen der Erfindung gehen aus den übrigen Ansprüchen hervor.

Die Reflektivität ist umso höher je größer der Unterschied zwischen den akustischen Impedanzen der Schichten des akustischen Spiegels ist. Metallschichten weisen eine besonders hohe Impedanz auf. Aufgrund der Verwendung von Metallschichten kann die Reflektivität des akustischen Spiegels besonders hoch sein.

Akustische Wellen werden durch einen Stapel reflektiert, der aus den isolierenden Schichten und den Metallschichten besteht. Die von den Dicken der Schichten erfüllte Reflexionsbedingung besteht beispielsweise darin, daß eine unter einem bestimmten Winkel auf das Substrat einfallende akustische Welle mit einer bestimmten Frequenz von den Schichten besonders gut reflektiert wird.

Die Dicken der isolierenden Schichten und der Metallschichten betragen vorzugsweise jeweils im wesentlichen λ/4, wobei λ die Wellenlänge einer akustischen Welle in der jeweiligen Schicht ist, die bei senkrechtem Einfall auf das Substrat besonders gut reflektiert wird. Die Wellenlänge hängt bei gleicher Frequenz der Welle von der Impedanz und von der spezifi.schen Dichte des Materials, das die Welle passiert, ab.

Die isolierenden Schichten weisen eine niedrige akustische Impedanz auf, während die Metallschichten eine hohe akustische Impedanz aufweisen. Die Dicken der Metallschichten sind also vorzugsweise gleich. Dasselbe gilt für die isolierenden Schichten. Die isolierenden Schichten und die Metallschichten haben jedoch in der Regel unterschiedliche Dicken.

Die unterste Schicht des Stapels ist beispielsweise eine der isolierenden Schichten.

Die oberste Schicht des Stapels ist vorzugsweise eine der Metallschichten.

Die Schichten des Stapels werden im wesentlichen konform aufgebracht.

Zueinander benachbarte der Schichten des Stapels grenzen vorzugsweise aneinander an. Es können zwischen den zueinander benachbarten Schichten jedoch auch im Vergleich zu den Schichten sehr dünne Zwischenschichten, z.B. Diffusionsbarrieren, angeordnet sein.

Da die Metallschichten in mindestens einer Vertiefung erzeugt werden, weisen die Metallschichten kleinere horizontale Flächen auf als das Substrat. Die Kapazität des akustischen Spiegels, die durch die Metallschichten gebildet wird, ist im Vergleich zu einem akustischen Spiegel, bei dem die Metallschichten das ganze Substrat bedecken, kleiner.

Eine Metallschicht, die das ganze Substrat bedeckt, bewirkt aufgrund eines hohen Schichtstreß eine Verbiegung des Substrats, die umso stärker ist je dicker die Metallschicht ist. Beim erfindungsgemäßen akustischen Spiegel wird die Verbiegung des Substrats vermieden, da die Metallschichten nicht das gesamte Substrat bedeckt, sondern nur in einer oder mehreren Vertiefung angeordnet ist.

Die Metallschichten werden jeweils zunächst ganzflächig abgeschieden und anschließend durch chemisch-mechanisches Polieren so strukturiert, daß sie innerhalb der jeweils zugehörigen Vertiefung angeordnet sind. Durch chemisch-mechanisches Polieren kann das Metall besser strukturiert werden als durch Ätzen mit Hilfe eines photolithographischen Prozesses. Grund dafür ist die Verbiegung des Substrats nach der ganzflächigen Abscheidung der Metallschicht, die zu Problemen bei photolithographischen Prozessen führt. Beispielsweise können bei einer starken Verbiegung Justiermarken zum Justieren von Masken nicht gefunden werden. Bei Verbiegung des Substrats ist darüber hinaus eine scharfe Abbildung bei Belichtung zur Erzeugung der Masken aus Photolack nicht mehr möglich. Beim erfindungsgemäßen Verfahren kann die Vertiefung mit Hilfe eines photolithographischen Verfahrens vor Abscheidung der Metallschicht, das heißt bei unverbogenem Substrat erzeugt werden. Die Form der Vertiefung definiert die Form der Metallschicht.

Das Verfahren ermöglicht die gleichzeitige Erzeugung von Kontakten oder Leitungen, die ebenfalls auf dem Substrat erzeugt werden, indem die Hilfsschicht entsprechend strukturiert wird und die dabei erzeugten Vertiefungen bzw. Kontaktlöcher durch das Abscheiden und das chemisch-mechanische Polieren der Metallschicht gefüllt werden. Auch hier erfolgt die erforderliche Lithographie bei unverbogenem Substrat.

Durch das Vorsehen der Hilfsschicht, die die Metallschicht umgibt, existiert zwischen einem Bereich, in dem die Metallschicht angeordnet ist, und einem Bereich, der neben der Metallschicht angeordnet ist, kein oder ein geringerer Höhenunterschied als wenn die Metallschicht durch Ätzen strukturiert worden wäre. Bei einem erfindungsgemäßen Verfahren treten also keine Topologieprobleme auf. Beim Ätzen von Metall mit Hilfe eines photolithographischen Verfahrens zur Erzeugung der Metallschicht ohne Verwendung der Hilfsschicht und der Vertiefung wird hingegen eine Stufe gebildet, durch die es zu Problemen bei Abscheidung weiterer Schichten bzw. bei photolithographischen Verfahren, bei denen sowohl ein Bereich der strukturierten Metallschicht als auch ein daneben angeordneten Bereich belichtet werden, kommt. Problematisch sind große Höhenunterschiede insbesondere bei photolithographischen Prozeßschritten, da schon beim Aufschleudern des Photolacks keine homogene Schicht ohne Dickenschwankungen erzeugt werden kann. Solche photolithographischen Schritte werden beispielsweise benötigt, wenn auf dem akustischen Spiegel z.B. Elektroden aufgebracht werden sollen.

Eine der Metallschichten kann in einer Vertiefung angeordnet sein, in der sonst keine weitere Metallschicht angeordnet ist. In diesem Fall wird nach Erzeugung der Vertiefung die Metallschicht abgeschieden und chemisch-mechanisch planarisiert. Soll über der Metallschicht eine weitere Metallschicht erzeugt werden, so wird auf der Hilfsschicht eine der isolierenden Schichten erzeugt und darüber eine weitere Hilfsschicht mit einer Vertiefung, die über der Vertiefung der Hilfsschicht angeordnet ist und die weitere Hilfsschicht durchtrennt. Die weitere Metallschicht wird in der Vertiefung der weiteren Hilfsschicht erzeugt.

Innerhalb der Vertiefung sind keine weitere Metallschicht und keine der isolierenden Schichten angeordnet. Da die Metallschicht durch chemisch-mechanisches Polieren strukturiert wird, ist die Tiefe der Vertiefung gleich oder größer als die Dicke der strukturierten Metallschicht. Vorzugsweise füllt die Metallschicht die Vertiefung im wesentlichen auf.

Eine obere Oberfläche der Metallschicht kann jedoch auch tiefer liegen als eine obere Oberfläche der Hilfsschicht. In diesem Fall füllen die Metallschicht und ein Teil der darüber angeordneten isolierenden Schicht die Vertiefung im wesentlichen auf. Da die isolierende Schicht auf der Hilfsschicht und der Metallschicht angeordnet ist, ist auch in diesem Fall die isolierende Schicht nicht innerhalb der Vertiefung angeordnet. Nur ein Teil der isolierenden Schicht ist innerhalb der Vertiefung angeordnet.

Es können z.B. alle Metallschichten jeweils in einer Vertiefung erzeugt werden. Die Vertiefungen sind übereinander angeordnet. Zwischen jeweils zwei der Hilfsschichten ist eine der isolierenden Schichten angeordnet.

Zur Verkleinerung des Prozeßaufwands ist es vorteilhaft, wenn mindestens zwei der Metallschichten und eine dazwischen angeordnete der isolierenden Schichten in derselben Vertiefung erzeugt werden. Dazu werden nach Erzeugung der Vertiefung ganzflächig zunächst die eine Metallschicht, dann die isolierende Schicht und dann die weitere Metallschicht abgeschieden. Anschließend werden die Metallschichten und die isolierende Schicht durch chemisch-mechanisches Polieren in einem Schritt abgetragen bis außerhalb der Vertiefung angeordnete Teile der beiden Metallschichten und der isolierenden Schicht entfernt werden.

Die unterste Schicht der Schichten, die in der Vertiefung erzeugt werden, kann eine andere der isolierenden Schichten oder eine der beiden Metallschichten sein.

Zur Erhöhung der Reflektivität des akustischen Spiegels können auch mehr als zwei Metallschichten in derselben Vertiefung erzeugt werden. Dazu muß die Hilfsschicht noch dicker gebildet werden und weitere isolierende Schichten und Metallschichten abgeschieden werden.

Die Tiefe der Vertiefung ist gleich oder größer als die Summe der Dicken aller innerhalb der Vertiefung angeordneten Schichten.

Eine horizontale Fläche der Metallschichten ist beispielsweise zwischen (20*20) um² und (400*400) µm² groß. Bei solch großen Flächen kann ein Effekt beim chemisch-mechanischen Polieren auftreten, der als Dishing bezeichnet wird. Dabei werden beim Dünnen großer Bereiche mittlere Teile stärker abgetragen als außen liegende Teile. Zur Verhinderung von Dishing ist es vorteilhaft, wenn auf der Metallschicht, die beim chemisch-mechanischen Polieren freiliegen würde, eine Stopschicht aufgebracht wird. Die Dicke der Stopschicht beträgt vorzugsweise zwischen 30nm und 100 nm oder ist mindestens 5 mal kleiner als die Dicke der Metallschicht. Die Stopschicht besteht aus einem Material, das bei dem chemisch-mechanischen Polieren des Metalls kaum angegriffen wird. Außerhalb der Vertiefung angeordnete Teile der Stopschicht werden entfernt. Anschließend wird die Metallschicht selektiv zur Stopschicht chemisch-mechanisch poliert. Die Stopschicht verhindert dabei, daß aufgrund von Dishing auch Teile der Metallschicht innerhalb der Vertiefung abgetragen werden. Die Tiefe der Vertiefung sollte dabei nicht kleiner sein als die Summe aller darin angeordneten Schichten inklusive der Stopschicht.

Werden mehrere Metallschichten in derselben Vertiefung erzeugt, so bedeckt die Stopschicht die oberste Metallschicht.

Die Stopschicht besteht beispielsweise aus Titan, TiN oder Siliziumnitrid.

Die Stopschicht kann beispielsweise durch chemisch-mechanisches Polieren strukturiert werden. Alternativ wird die Stopschicht durch ein photolithographisches Verfahren strukturiert. Als Methode ist dabei zum Beispiel Trockenätzen geeignet.

Nach Strukturierung der Metallschichten können die darauf angeordneten Stopschichten entfernt werden.

Die Metallschichten bestehen beispielsweise aus Wolfram. Alternativ können die Metallschichten aus Molybdän oder Platin bestehen.

Die isolierenden Schichten bestehen beispielsweise aus SiO₂ oder aus Siliziumnitrid.

Die Hilfsschichten bestehen beispielsweise aus SiO₂ oder aus Siliziumnitrid.

Damit die Vertiefungen eine definierte Tiefe erhalten, können die Hilfsschichten selektiv zu den isolierenden Schichten ätzbar sein. Zur Erzeugung der Vertiefungen werden die Hilfsschichten selektiv zu den isolierenden Schichten geätzt.

Alternativ wird zwischen der Hilfsschicht und der darunter angeordneten isolierenden Schicht eine Ätzstopschicht erzeugt, die selektiv zur Hilfsschicht ätzbar ist. Zur Erzeugung der Vertiefung wird die Hilfsschicht selektiv zur Atzstopschicht geätzt bis ein Teil der Ätzstopschicht freigelegt wird.

Der Teil der Ätzstopschicht kann anschließend entfernt werden oder wirkt als Teil der isolierenden Schicht.

Vorzugsweise sind zwei oder drei Metallschichten vorgesehen.

Im folgenden werden Ausführungsbeispiele der Erfindung anhand der Figuren näher erläutert.
- Figur 1: zeigt einen Querschnitt durch ein erstes Substrat, nachdem eine erste isolierende Schicht, eine erste Atzstopschicht, eine erste Hilfsschicht, eine erste Vertiefung, eine erste Metallschicht und eine erste Stopschicht erzeugt wurden.
- Figur 2: zeigt den Querschnitt aus Figur 1, nachdem die Stopschicht strukturiert wurde.
- Figur 3: zeigt den Querschnitt aus Figur 2, nachdem die erste Metallschicht strukturiert wurde.
- Figur 4: zeigt den Querschnitt aus Figur 3, nachdem eine zweite isolierende Schicht, eine zweite Ätzstopschicht, eine zweite Hilfsschicht, eine zweite Vertiefung, eine zweite Metallschicht und eine zweite Stopschicht erzeugt und strukturiert wurden.
- Figur 5: zeigt einen Querschnitt durch ein zweites Substrat, nachdem eine erste isolierende Schicht, eine erste Ätzstopschicht, eine Hilfsschicht, eine Vertiefung, eine erste Metallschicht, eine zweite isolierende Schicht, eine zweite Metallschicht und eine Stopschicht erzeugt wurden.
- Figur 6: zeigt den Querschnitt aus Figur 5, nachdem die erste Metallschicht, die zweite isolierende Schicht und die zweite Metallschicht strukturiert wurden.
- Figur 7: zeigt den Querschnitt aus Figur 6, nachdem eine weitere isolierende Schicht, eine zweite Ätzstopschicht, eine weitere Hilfsschicht, eine weitere Vertiefung, eine weitere Metallschicht und eine weitere Stopschicht erzeugt wurden.

Die Figuren sind nicht maßstabsgetreu.

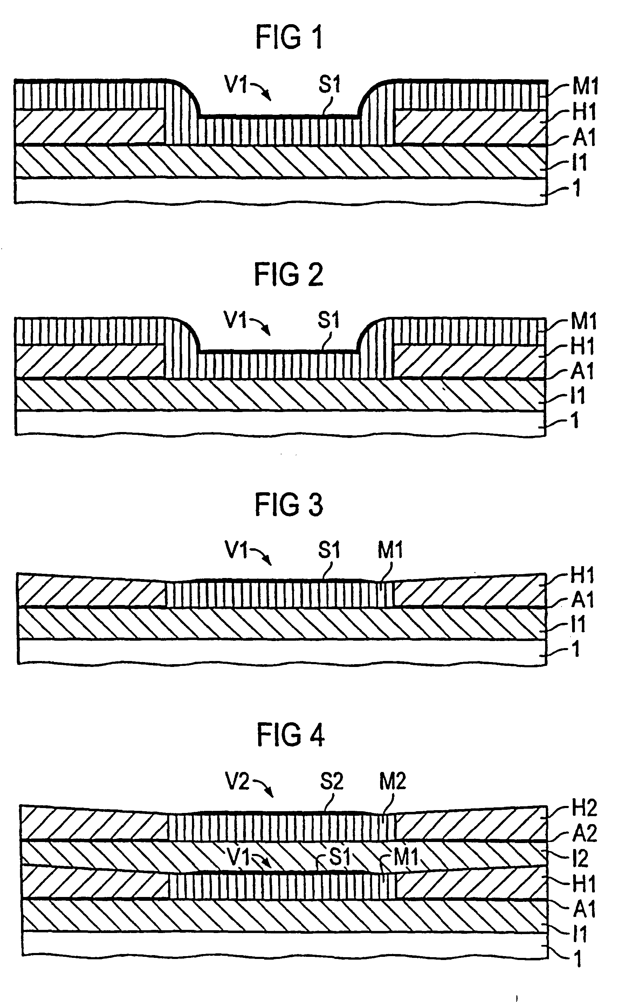

In einem ersten Ausführungsbeispiel ist als Ausgangsmaterial ein erstes Substrat 1 aus Silizium vorgesehen (siehe Figur 1).

Auf dem ersten Substrat 1 wird eine ca. 0,8 µm dicke erste isolierende Schicht I1 aus SiO₂ erzeugt (siehe Figur 1).

Auf der ersten isolierenden Schicht Il wird eine ca. 100nm dicke erste Ätzstopschicht A1 aus Siliziumnitrid erzeugt. Darüber wird eine ca. 0,9µm dicke erste Hilfsschicht H1 aus SiO₂ erzeugt (siehe Figur 1).

Mit Hilfe einer ersten Photolackmaske (nicht dargestellt) wird in der ersten Hilfsschicht H1 eine erste Vertiefung V1 erzeugt, indem zunächst SiO₂ selektiv zu Siliziumnitrid geätzt wird bis ein Teil der Atzstopschicht freigelegt wird, und anschließend der Teil der Atzstopschicht A1 selektiv zu SiO₂ entfernt wird. Die erste Vertiefung V1 durchtrennt die erste Hilfsschicht H1 und die Ätzstopschicht A1. Die erste Vertiefung V1 weist einen quadratischen horizontalen Querschnitt mit einer Seitenlänge von ca. 200 µm auf (siehe Figur 1). Die erste Vertiefung V1 reicht bis zur ersten isolierenden Schicht I1.

Zur Erzeugung einer ersten Metallschicht M1 wird Wolfram in einer Dicke von ca. 0,7 µm abgeschieden (siehe Figur 1). Darüber wird eine ca. 50 nm dicke erste Stopschicht S1 aus Titan erzeugt.

Durch chemisch-mechanisches Polieren der ersten Stopschicht S1 selektiv zur ersten Metallschicht M1 werden außerhalb der ersten Vertiefung V1 angeordnete Teile der ersten Stopschicht S1 entfernt (siehe Figur 2).

Anschließend wird die erste Metallschicht M1 selektiv zur ersten Hilfsschicht H1 und zur Stopschicht S1 durch chemisch mechanisches Polieren abgetragen, bis außerhalb der ersten Vertiefung V1 angeordnete Teile der ersten Metallschicht M1 entfernt werden (siehe Figur 3). Die strukturierte erste Metallschicht M1 und die strukturierte erste Stopschicht S1 sind innerhalb der ersten Vertiefung V1 angeordnet.

Auf der ersten Hilfsschicht H1 und der mit der ersten Stopschicht S1 bedeckten ersten Metallschicht M1 wird eine ca. 1,6 µm dicke zweite isolierende Schicht I2 aus SiO₂ erzeugt (siehe Figur 4).

Darüber wird eine ca. 100nm dicke zweite Ätzstopschicht A2 aus Siliziumnitrid erzeugt. Darüber wird eine 0,9µm dicke zweite Hilfsschicht H2 aus SiO₂ erzeugt, in der wie bei der ersten Hilfsschicht H1 eine zweite Vertiefung V2 erzeugt wird. Die zweite Vertiefung V2 ist wie die erste Vertiefung V1 ausgestaltet und ist direkt über der ersten Vertiefung V1 angeordnet.

Anschließend werden eine ca. 0.7 µm dicke zweite Metallschicht M2 aus Wolfram und darüber eine ca. 50nm dicke zweite Stopschicht S2 aus Titan erzeugt (siehe Figur 4). Die zweite Stopschicht S2 und die zweite Metallschicht M2 werden wie die erste Stopschicht S1 und die erste Metallschicht M1 durch chemisch-mechanisches Polieren strukturiert (siehe Figur 4).

Durch das beschriebene Verfahren wird ein akustischer Spiegel erzeugt, durch den aufgrund der ersten isolierenden Schicht I1, der ersten Metallschicht M1, der zweiten isolierenden Schicht I2 und der zweiten Metallschicht M2 akustische Wellen mit einer Frequenz von ca. 1,8GHz bei senkrechtem Einfall auf das Substrat 1 besonders gut reflektiert werden können.

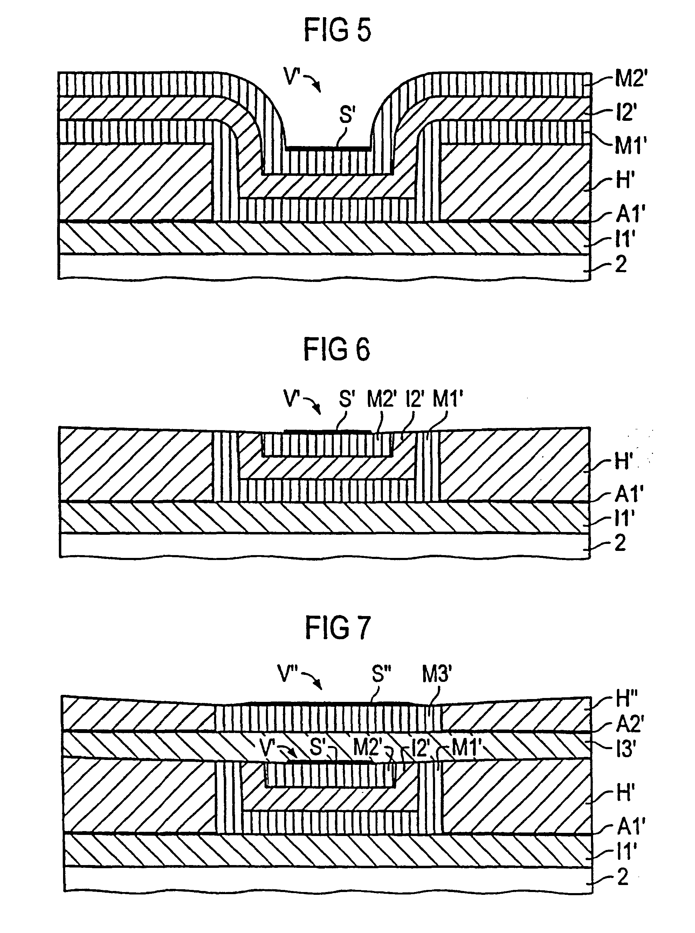

Bei einem zweiten Ausführungsbeispiel ist als Ausgangsmaterial ein zweites Substrat 2 aus Silizium vorgesehen (siehe Figur 5).

Auf dem zweiten Substrat 2 wird eine ca. 0,8 µm dicke erste isolierende Schicht I1' aus SiO₂ erzeugt.

Auf der ersten isolierenden Schicht I1' wird eine ca. 100nm dicke erste Atzstopschicht A1' aus Siliziumnitrid erzeugt. Darüber wird eine ca. 2,7 µm dicke erste Hilfsschicht H' aus SiO₂ erzeugt (siehe Figur 5).

Mit Hilfe einer ersten Photolackmaske (nicht dargestellt) wird die erste Hilfsschicht H' strukturiert. Dabei wird zunächst SiO₂ selektiv zur Siliziumnitrid geätzt, bis ein Teil der ersten Atzstopschicht A1' freigelegt wird. Anschließend wird der Teil der Ätzstopschicht A1' entfernt. Dadurch wird in der ersten Hilfsschicht H' eine erste Vertiefung V' erzeugt, die bis zur ersten isolierenden Schicht I1' reicht und einen horizontalen Querschnitt aufweist, der quadratisch ist und eine Seitenlänge von ca. 200 µm aufweist.

Anschließend wird eine ca. 0,7 µm dicke erste Metallschicht M1' aus Wolfram erzeugt. Darüber wird eine ca. 0,8 µm dicke zweite isolierende Schicht I2' aus SiO₂ erzeugt. Darüber wird eine ca. 0,7 µm dicke zweite Metallschicht M2' aus Wolfram erzeugt (siehe Figur 5).

Auf der zweiten Metallschicht M2' wird eine ca. 50 nm dicke erste Stopschicht S' aus Titan erzeugt.

Mit Hilfe einer zweiten Photolackmaske (nicht dargestellt) wird die erste Stopschicht S' so strukturiert, daß außerhalb der ersten Vertiefung V' angeordnete Teile der ersten Stopschicht S' entfernt werden (siehe Figur 5).

Anschließend werden die zweite Metallschicht M2', die zweite isolierende Schicht I2' und die erste Metallschicht M1' durch chemisch-mechanisches Polieren selektiv zur ersten Stopschicht S' und zur ersten Hilfsschicht H' abgetragen, bis außerhalb der ersten Vertiefung V' angeordnete Teile der zweiten Metallschicht M2', der zweiten isolierenden Schicht I2' und der ersten Metallschicht M1' entfernt werden (siehe Figur 6).

Anschließend wird eine ca. 0,8 µm dicke dritte isolierende Schicht I3' aus SiO₂ erzeugt. Auf der dritten isolierenden Schicht I3' wird eine ca. 100nm dicke zweite Ätzstopschicht A2' aus Siliziumnitrid erzeugt. Darüber wird eine ca. 0,9 µm dicke zweite Hilfsschicht H'' aus SiO₂ erzeugt. Mit Hilfe einer dritten Photolackmaske (nicht dargestellt) wird die zweite Hilfsschicht H'' strukturiert. Dabei wird in der zweiten Hilfsschicht H'' eine zweite Vertiefung V'' erzeugt, die bis zur dritten isolierenden Schicht I3' reicht.

Anschließend wird eine ca. 0,7 µm dicke dritte Metallschicht M3' aus Wolfram erzeugt. Auf der dritten Metallschicht M3' wird eine ca. 50 nm dicke zweite Stopschicht S" aus Titan erzeugt (siehe Figur 7). Mit Hilfe einer vierten Photolackmaske (nicht dargestellt) wird die zweite Stopschicht S" so strukturiert, daß außerhalb der zweiten Vertiefung V" angeordnete Teile der zweiten Stopschicht S" entfernt werden. Anschließend wird die dritte Metallschicht M3' durch chemisch-mechanisches Polieren selektiv zur zweiten Stopschicht S'' und zur zweiten Hilfsschicht H'' abgetragen, bis außerhalb der zweiten Vertiefung V'' angeordnete Teile der zweiten Metallschicht M3' entfernt werden (siehe Figur 7).

Durch dieses Verfahren wird ein akustischer Spiegel erzeugt, bei dem akustische Wellen durch die erste isolierende Schicht I1', die erste Metallschicht M1', die zweite isolierende Schicht I2', die zweite Metallschicht M2', die dritte isolierende Schicht I3' und die dritte Metallschicht M3' reflektiert werden.

Die erste Metallschicht M1' bedeckt Flanken und einen Boden der ersten Vertiefung V' ohne die erste Vertiefung V' aufzufüllen.

Es sind viele Variationen der Ausführungsbeispiele denkbar, die ebenfalls im Rahmen der Erfindung liegen. Beispielsweise können Abmessungen der beschriebenen Schichten und Vertiefungen an die jeweiligen Erfordernisse angepaßt werden. Zum Reflektieren von akustischen Wellen mit größeren bzw. kleineren Wellenlängen werden die Dicken der ersten isolierenden Schicht, der zweiten isolierenden Schicht, der ersten Metallschicht und der zweiten Metallschicht größer bzw. kleiner gewählt. Zur besseren Reflektivität können mehr als zwei bzw. drei isolierende Schichten und zwei bzw. drei Metallschichten erzeugt werden. Die Stopschichten können nach dem chemisch mechanischen Polieren entfernt werden. Für die Metallschichten, die Hilfsschichten, die Stopschichten, die Atzstopschichten und die isolierenden Schichten können auch andere Materialien gewählt werden.

## Patentansprüche

1. Akustischer Spiegel,
- bei dem mindestens zwei isolierende Schichten (I1, I2)und mindestens zwei Metallschichten (M1, M2) auf einem Substrat (1) alternierend übereinander angeordnet sind,
- bei dem die isolierenden Schichten (I1, I2) im wesentlichen dieselbe Dicke aufweisen
- bei dem die Metallschichten (M1, M2) im wesentlichen dieselbe Dicke aufweisen,
- bei dem die Dicken der isolierenden Schichten (I1, 12) und der Metallschichten (M1, M2) derart sind, daß eine Reflexionsbedingung erfüllt wird,
**gekennzeichnet dadurch, dass** mindestens die Metallschichten (M1, M2) innerhalb mindestens einer Vertiefung (V1, V2) einer Hilfsschicht (H1, H2) angeordnet sind.

2. Akustischer Spiegel nach Anspruch 1,
- mit mindestens zwei Hilfsschichten (H1, H2), in denen jeweils eine Vertiefung (V1, V2) angeordnet ist,
- bei dem die mindestens zwei isolierenden Schichten zumindest eine erste isolierende Schicht (I1) und eine zweite isolierende Schicht (I2) umfassen,
- bei dem die Vertiefungen (V1, V2) der Hilfsschichten (H1, H2) übereinander angeordnet sind,
- bei dem zwischen jeweils zwei der Hilfsschichten (H1, H2) die zweite der mindestens zwei isolierenden Schichten (I2) angeordnet ist
- bei dem mindestens eine der Metallschichten (M1) innerhalb der Vertiefung (V1) derjenigen der Hilfsschichten (H1) angeordnet ist, innerhalb der sonst keine weitere Metallschicht (M2) angeordnet ist,
- bei dem die eben genannte Vertiefung (V1) ihre Hilfsschicht (H1) durchtrennt,
- bei dem die eben genannte Hilfsschicht (H1) auf der ersten der mindestens zwei isolierenden Schichten (I1) angeordnet ist,
- bei dem mindestens eine andere der Metallschichten (M2) innerhalb der Vertiefung (V2) einer anderen als der eben genannten Hilfsschichten (H2) angeordnet ist.

3. Akustischer Spiegel nach Anspruch 1 oder 2,
- bei dem mindestens zwei der Metallschichten (M1', M2') und eine dazwischen angeordnete der isolierenden Schichten (I2') innerhalb derselben Vertiefung (V') angeordnet sind,
- bei dem die unterste der beiden soeben genannten Metallschichten (M1') einen Boden und Flanken dieser Vertiefung (V') im wesentlichen vollständig bedeckt, so daß ein mittlerer Bereich der untersten Metallschicht (M1') abgesenkt ist.

4. Akustischer Spiegel nach einem der Ansprüche 1 bis 3,
- bei dem auf derjenigen der Metallschichten (M1), über der keine weitere Metallschicht innerhalb derjenigen Vertiefung (V1) angeordnet ist, in welcher die soeben genannte Metallschicht (M1) angeordnet ist, eine Stopschicht (S1) innerhalb der Vertiefung (V1) angeordnet ist,
- bei der die Tiefe der soeben genannten Vertiefung (V1) nicht kleiner als die Summe der Dicken aller Schichten (M1, S1), die in der Vertiefung (V1) angeordnet sind, ist.

5. Akustischer Spiegel nach einem der Ansprüche 1 bis 4,
- bei dem zwischen mindestens einer der isolierenden Schichten (I1) und einer der darauf angeordneten Hilfsschichten (H1) eine Ätzstopschicht (A1) angeordnet ist.

6. Akustischer Spiegel nach einem der Ansprüche 1 bis 5,
- bei dem die Metallschichten (M1, M2) aus Wolfram bestehen,
- bei dem die isolierenden Schichten (I1, I2) aus SiO₂ oder aus Siliziumnitrid bestehen.

7. Verfahren zur Erzeugung eines akustischen Spiegels,
- bei dem mindestens zwei isolierende Schichten (I1, I2) und mindestens zwei Metallschichten (M1, M2) auf einem Substrat (1) alternierend übereinander erzeugt werden,
- bei dem die isolierenden Schichten (I1, I2) mit im wesentlichen derselben Dicke erzeugt werden,
- bei dem die Metallschichten (M1, M2) mit im wesentlichen derselben Dicke erzeugt werden,
- bei dem die Dicken der isolierenden Schichten (I1, I2) und der Metallschichten (M1, M2) derart sind, daß eine Reflexionsbedingung erfüllt wird,
**gekennzeichnet dadurch, dass** die Metallschichten (M1, M2) so erzeugt werden, daß sie jeweils nach Erzeugung mindestens einer Hilfsschicht (H1, H2), in der eine Vertiefung (V1, V2) erzeugt wird, abgeschieden und durch chemisch-mechanisches Polieren abgetragen werden, bis außerhalb der Vertiefung (V1, V2) angeordnete Teile der jeweiligen Metallschicht (M1, M2) entfernt werden.

8. Verfahren nach Anspruch 7,
- bei dem mindestens zwei Hilfsschichten (H1, H2) erzeugt werden, in denen jeweils eine Vertiefung (V1, V2) so erzeugt wird, daß die Vertiefungen (V1, V2) der Hilfsschichten (H1, H2) übereinander angeordnet sind,
- bei dem die erzeugten mindestens zwei isolierenden Schichten zumindest eine erste isolierende Schicht (I1) und eine zweite isolierende Schicht (I2) umfassen,
- bei dem zwischen jeweils zwei der Hilfsschichten (H1, H2) die zweite der isolierenden Schichten (I2) erzeugt wird,
- bei dem mindestens eine der Metallschichten (M1) innerhalb einer Vertiefung (V1) derjenigen der Hilfsschichten (H1) erzeugt wird, innerhalb welcher sonst keine weitere Metallschicht erzeugt wird,
- bei dem die eben genannte Vertiefung (V1) ihre Hilfsschicht (H1) durchtrennt,
- bei dem die eben genannte Hilfsschicht (H1) auf der ersten der isolierenden Schichten (I1) erzeugt wird,
- bei dem mindestens eine weitere der Metallschichten (M2) innerhalb der Vertiefung (V2) einer weiteren der Hilfsschichten (H2) erzeugt wird.

9. Verfahren nach Anspruch 8,
- bei dem die zweite der isolierenden Schichten (I2) auf derjenigen Hilfsschicht (H1) erzeugt wird, innerhalb welcher sonst keine weitere Metallschicht erzeugt wird
- bei dem die weitere Hilfsschicht (H2) auf der zweiten der isolierenden Schichten (I2) erzeugt wird,
- bei dem die Vertiefung (V2), die in der weiteren Hilfsschicht (H2) erzeugt wird, bis zur zweiten isolierenden Schicht (I2) reicht,
- bei dem die weitere Metallschicht (M2) abgeschieden wird und durch chemisch-mechanisches Polieren abgetragen wird, bis außerhalb der Vertiefung (V2) der weiteren Hilfsschicht (H2) angeordnete Teile der weiteren Metallschicht (M2) entfernt werden.

10. Verfahren nach einem der Ansprüche 7 bis 9,
- bei dem nach Erzeugung der Vertiefung (V') in einer der Hilfsschichten darin mindestens zwei der Metallschichten (M1', M2') und eine dazwischen angeordnete der isolierenden Schichten (I2') abgeschieden werden,
- bei dem die beiden soeben genannten Metallschichten (M1', M2') und die isolierende Schicht (I2') durch chemisch-mechanisches Polieren abgetragen werden, bis außerhalb der soeben genannten Vertiefung (V') angeordnete Teile der soeben genannten Metallschichten (M1', M2') und der isolierenden Schicht (I2') entfernt werden.

11. Verfahren nach einem der Ansprüche 7 bis 10,
- bei dem nach dem Abscheiden und vor Abtragen mindestens einer der Metallschichten (M1), über der keine weitere Metallschicht innerhalb der Vertiefung (V1) erzeugt wird, in welcher die Metallschicht (M1) erzeugt wird, eine Stopschicht (S1) innerhalb der Vertiefung (V1) aufgebracht wird,
- bei dem die Tiefe der soeben genannten Vertiefung (V1) nicht kleiner als die Summe der Dicken aller Schichten (M1, S1), die in der Vertiefung (V1) angeordnet sind, ist,
- bei dem Teile der Stopschicht (S1), die außerhalb der Vertiefung (V1) angeordnet sind, entfernt werden,
- bei dem die Metallschicht (M1) selektiv zur Stopschicht (S1) durch chemisch-mechanisches Polieren abgetragen wird.

12. Verfahren nach einem der Ansprüche 7 bis 11,
- bei dem zwischen mindestens einer der isolierenden Schichten (I1) und einer der darauf angeordneten Hilfsschichten (H1) eine Ätzstopschicht (A1) erzeugt wird.

13. Verfahren nach einem der Ansprüche 7 bis 12,
- bei dem die Metallschichten (M1, M2) aus Wolfram erzeugt werden,
- bei dem die isolierenden Schichten (I1, I2) aus SiO₂ oder aus Siliziumnitrid erzeugt werden.

## Claims

1. Acoustic mirror,
- in which at least two insulating layers (I1, I2) and at least two metal layers (M1, M2) are arranged alternately on top of one another in a substrate (1),
- in which the insulating layers (I1, I2) are of substantially the same thickness,
- in which the metal layers (M1, M2) are of substantially the same thickness,
- in which the thicknesses of the insulating layers (I1, I2) and of the metal layers (M1, M2) are such that a reflection condition is satisfied,
**characterized in that** at least the metal layers (M1, M2) are arranged inside at least one recess (V1, V2) in an auxiliary layer (H1, H2).

2. Acoustic mirror according to Claim 1,
- having at least two auxiliary layers (H1, H2), in each of which there is a recess (V1, V2),
- in which the recesses (V1, V2) in the auxiliary layers (H1, H2) are arranged on top of one another,
- in which a first of the at least two insulating layers (I2) is arranged between in each case two of the auxiliary layers (H1, H2),
- in which at least one of the metal layers (M1) is arranged inside the recess (V1) in that one of the auxiliary layers (H1) within which there is otherwise no further metal layer (M2),
- in which the abovementioned recess (V1) passes all the way through its auxiliary layer (H1),
- in which the abovementioned auxiliary layer (H1) is arranged on a second of the at least two insulating layers (I1),
- in which at least one of the other metal layers (M2) is arranged inside the recess (V2) in a different auxiliary layer from the abovementioned auxiliary layers (H2).

3. Acoustic mirror according to Claim 1 or 2,
- in which at least two of the metal layers (M1', M2') and one of the insulating layers (I2') arranged therebetween are arranged inside the same recess (V'),
- in which the lowermost of the two abovementioned metal layers (M1') substantially completely covers a base and flanks of this recess (V'), so that a central region of the lowermost metal layer (M1') is lowered.

4. Acoustic mirror according to one of Claims 1 to 3,
- in which, on that one of the metal layers (M1) above which there is no further metal layer within that recess (V1) in which the abovementioned metal layer (M1) is arranged, a stop layer (S1) is arranged inside the recess (V1),
- in which the depth of the abovementioned recess (V1) is not less than the sum of the thicknesses of all the layers (M1, S1) which are arranged in the recess (V1).

5. Acoustic mirror according to one of Claims 1 to 4,
- in which an etching stop layer (A1) is arranged between at least one of the insulating layers (I1) and one of the auxiliary layers (H1) arranged thereon.

6. Acoustic mirror according to one of Claims 1 to 5,
- in which the metal layers (M1, M2) consist of tungsten,
- in which the insulating layers (I1, I2) consist of SiO₂ or of silicon nitride.

7. Method for producing an acoustic mirror,
- in which at least two insulating layers (I1, I2) and at least two metal layers (M1, M2) are produced alternately on top of one another on a substrate (1),
- in which the insulating layers (I1, I2) are produced with substantially the same thickness,
- in which the metal layers (M1, M2) are produced with substantially the same thickness,
- in which the thicknesses of the insulating layers (I1, I2) and of the metal layers (M1, M2) are such that a reflection condition is satisfied,
**characterized in that** the metal layers (M1, M2) are produced in such a way that they are in each case deposited after at least one auxiliary layer (H1, H2), in which a recess (V1, V2) is produced, has been produced and are abraded by chemical mechanical polishing until all the parts of the respective metal layer (M1, M2) which are arranged outside the recess (V1, V2) have been removed.

8. Method according to Claim 7,
- in which at least two auxiliary layers (H1, H2) are produced, in each of which a recess (V1, V2) is produced in such a way that the recesses (V1, V2) in the auxiliary layers (H1, H2) are arranged on top of one another,
- in which a first of the insulating layers (I2) is produced between in each case two of the auxiliary layers (H1, H2),
- in which at least one of the metal layers (M1) is produced inside a recess (V1) in that one of the auxiliary layers (H1) within which otherwise no further metal layer is produced,
- in which the abovementioned recess (V1) passes all the way through its auxiliary layer (H1),
- in which the abovementioned auxiliary layer (H1) is produced on a second of the insulating layers (I1),
- in which at least one more of the metal layers (M2) is produced within the recess (V2) in another of the auxiliary layers (H2).

9. Method according to Claim 8,
- in which another of the insulating layers (I2) is produced on that auxiliary layer (H1) within which otherwise no further metal layer is produced,
- in which the further auxiliary layer (H2) is produced on the first of the insulating layers (I2),
- in which the recess (V2) which is produced in the further auxiliary layer (H2) extends as far as the first insulating layers (I2),
- in which the further metal layer (M2) is deposited and is abraded by chemical mechanical polishing until parts of the further metal layer (M2) which are arranged outside the recess (V2) in the further auxiliary layer (H2) have been removed.

10. Method according to one of Claims 7 to 9,
- in which, after the recess (V') has been produced within one of the auxiliary layers, at least two of the metal layers (M1', M2') and one of the insulating layers (I2') arranged therebetween are deposited therein,
- in which the two abovementioned metal layers (M1', M2') and the insulating layer (I2') are abraded by chemical mechanical polishing until parts of the abovementioned metal layers (M1', M2') and of the insulating layer (I2') which are arranged outside the abovementioned recess (V') have been removed.

11. Method according to one of Claims 7 to 10,
- in which, after the deposition and prior to the abrasion of at least one of the metal layers (M1), above which no further metal layer is produced within the recess (V1) in which the metal layer (M1) is produced, a stop layer (S1) is applied inside the recess (V1),
- in which the depth of the abovementioned recess (V1) is not less than the sum of the thicknesses of all the layers (M1, S1) which are arranged in the recess (V1),
- in which parts of the stop layer (S1) which are arranged outside the recess (V1) are removed,
- in which the metal layer (M1) is abraded selectively with respect to the stop layer (S1) by chemical mechanical polishing.

12. Method according to one of Claims 7 to 11,
- in which an etching stop layer (A1) is produced between at least one of the insulating layers (I1) and one of the auxiliary layers (H1) arranged thereon.

13. Method according to one of Claims 7 to 12,
- in which the metal layers (M1, M2) are produced from tungsten,
- in which the insulating layers (I1, I2) are produced from SiO₂ or from silicon nitride.

## Revendications

1. Miroir acoustique,
- dans lequel au moins deux couches (I1, I2) isolantes et au moins deux couches (M1, M2) métalliques sont superposées en alternance sur un substrat (1),
- dans lequel les couches (I1, I2) isolantes ont sensiblement la même épaisseur,
- dans lequel les couches (M1, M2) métalliques ont sensiblement la même épaisseur,
- dans lequel les épaisseurs des couches (I1, I2) isolantes et des couches (M1, M2) métalliques sont telles qu'une condition de réflexion est satisfaite,
**caractérisé en ce qu'**au moins les couches (M1, M2) métalliques sont disposées à l'intérieur d'au moins une cavité (V1, V2) d'une couche (H1, H2) auxiliaire.

2. Miroir acoustique suivant la revendication 1,
- comprenant au moins deux couches (H1, H2) auxiliaires dans lesquelles est disposée respectivement une cavité (V1, V2),
- dans lequel les au moins deux couches isolantes comprennent au moins une première couche (I1) isolante et une deuxième couche (I2) isolante,
- dans lequel les cavités (V1, V2) des couches (H1, H2) isolantes sont disposées l'une au-dessus de l'autre,
- dans lequel la deuxième des au moins deux couches (I2) isolantes est disposée entre respectivement deux des couches (H1, H2) auxiliaires,
- dans lequel au moins l'une des couches (M1, M2) métalliques est disposée à l'intérieur de la cavité (V1) de celles des couches (H1) auxiliaires à l'intérieur de laquelle il n'y a pas d'autre couche (M2) métallique,
- dans lequel la cavité (V1) qui vient d'être mentionnée traverse sa couche (H1) auxiliaire,
- dans lequel la couche (H1) auxiliaire qui vient d'être mentionnée est disposée sur la première des au moins deux couches (I1) isolantes,
- dans lequel au moins une autre des couches (M2) métalliques est disposée dans la cavité (V2) d'une autre couche auxiliaire que la couche (H2) auxiliaire qui vient d'être mentionnée.

3. Miroir acoustique suivant la revendication 1 ou 2,
- dans lequel au moins deux des couches (M1', M2') métalliques et l'une, disposée entre elles, des couches (I2') isolantes sont disposées à l'intérieur de la même cavité (V'),
- dans lequel la plus basse des deux couches (M1') métalliques'qui viennent d'être mentionnées recouvrent un fond et des flancs de cette cavité (V') sensiblement complètement de sorte qu'une partie intermédiaire de la couche (M1') métallique la plus basse est abaissée.

4. Miroir acoustique suivant l'une des revendications 1 à 3,
- dans lequel sur celles des couches M1) métalliques, sur laquelle n'est pas disposée une autre couche métallique à l'intérieur de la cavité dans laquelle la couche (M1) métallique qui vient d'être mentionnée est disposée, une couche (S1) d'arrêt est disposée à l'intérieur de la cavité (V1),
- dans lequel la profondeur de la cavité (V1) qui vient d'être mentionnée n'est pas plus petite que la somme des épaisseurs de toutes les couches (M1, S1) qui sont disposées dans la cavité (V1).

5. Miroir acoustique suivant l'une des revendications 1 à 4,
- dans lequel entre au moins l'une des couches (I1) isolantes et l'une des couches (H1) auxiliaires disposées dessus est disposée une couche (A1) d'arrêt d'attaque.

6. Miroir acoustique suivant l'une des revendications 1 à 5,
- dans lequel les couches (M1, M2) métalliques sont en tungstène,
- dans lequel les couches (I1, I2) isolantes sont en SiO₂ ou en nitrure de silicium.

7. Procédé de production d'un miroir acoustique,
- dans lequel on produit les unes au dessus des autres en alternance au moins deux couches (I1, I2) isolantes et au moins deux couches (M1, M2) métalliques sur un substrat,
- dans lequel on produit les couches (I1, I2) isolantes en leur donnant sensiblement la même épaisseur,
- dans lequel on produit les couches (M1, M2) métalliques en leur donnant sensiblement la même épaisseur,
- dans lequel les épaisseurs des couches (I1, I2) isolantes et des couches (M1, M2) métalliques sont telles qu'une condition de réflexion est satisfaite,
**caractérisé en ce que** l'on produit les couches (M1, M2) métalliques en les déposant respectivement après production d'au moins une couche (H1, H2) auxiliaire dans laquelle est produite une cavité (V1, V2) et en retirant de la matière par polissage chémio-mécanique jusqu'à ce que des parties, disposées à l'extérieur de la cavité (V1, V2), de la couche (M1, M2) métallique respective soit éliminée.

8. Procédé de production d'un miroir acoustique suivant la revendication 7,
- dans lequel on produit au moins deux couches (H1, H2) auxiliaires dans lesquelles on produit respectivement une cavité (V1, V2) de façon à ce que les cavités (V1, V2) des couches (H1, H2) auxiliaires soient disposées l'une au-dessus de l'autre,
- dans lequel les au moins deux couches isolantes produites entourent au moins une première couche (I1) isolante et une deuxième couche (I2) isolante,
- dans lequel on produit entre respectivement deux des couches (H1, H2) auxiliaires les deuxièmes des couches (I2) isolantes,
- dans lequel on produit au moins l'une des couches (M1) métalliques à l'intérieur d'une cavité (V1) de celles des couches (H1) auxiliaires à l'intérieur de laquelle il n'y a pas sinon d'autre couche métallique,
- dans lequel la cavité (V1) qui vient d'être mentionnée traverse sa couche (H1 ) auxiliaire,
- dans lequel on produit la couche (H1) auxiliaire qui vient d'être mentionnée sur la première des couches (I1) isolante,
- dans lequel on produit au moins une autre des couches (M2) métalliques à l'intérieur de la cavité (V2) d'une autre des couches (H2) auxiliaires.

9. Procédé suivant la revendication 8,
- dans lequel on produit la deuxième des couches (I2) isolantes sur celles des couches (H1) auxiliaires à l'intérieur desquelles il n'est pas produit sinon d'autres couches métalliques,
- dans lequel on produit l'autre couche (H2) auxiliaire sur la deuxième des couches (I2) isolantes,
- dans lequel la cavité (V2) qui est produite dans l'autre couche (H2) auxiliaire va jusqu'à la deuxième couche (I2) isolante,
- dans lequel on dépose l'autre couche (M2) métallique et on enlève de la matière par polissage chémio-mécanique jusqu'à ce que des parties, disposées à l'extérieur de la cavité (V2) de l'autre couche (H2) auxiliaire, de l'autre couche (M2) métallique soit éliminée.

10. Procédé suivant l'une des revendications 7 à 9,
- dans lequel après production de la cavité (V') dans l'une des couches auxiliaires on y dépose au moins deux couches (M1', M2') métalliques et une couche (I2') isolante interposées entre elles,
- dans lequel on enlève de la matière des deux couches (M1', M2') métalliques qui viennent d'être mentionnées et de la couche (I2') isolante par polissage chémio-mécanique jusqu'à ce que des parties, disposées à l'extérieur de la cavité (V') qui vient d'être mentionnée, des couches (M1', M2') métalliques qui viennent d'être mentionnées et de la couche (I2') isolante soient éliminées.

11. Procédé suivant l'une des revendications 7 à 10,
- dans lequel après le dépôt de l'une des couches (M1) métalliques et avant d'en avoir enlevé de la matière, couche métallique sur laquelle pas d'autre couche métallique n'est produite à l'intérieur de la cavité (V1) dans laquelle, la couche (M1) métallique est produite, on dépose une couche (S1) d'arrêt à l'intérieur de la cavité (V1),
- dans lequel la profondeur de la cavité (V1) qui vient d'être mentionnée n'est pas plus petite que la somme des épaisseurs de toutes les couches (M1, S1) qui sont disposées dans la cavité (V1),
- dans lequel on élimine des parties de la couche (S1) d'arrêt qui se trouvent à l'extérieur de la cavité (V1 ),
- dans lequel on enlève de la matière de la couche (M1) métallique sélectivement par rapport à la couche (S1) d'arrêt par polissage chémio-mécanique.

12. Procédé suivant l'une des revendications 7 à 11,
- dans lequel on produit entre au moins l'une des couches (I1) isolantes et l'une des couches (H1) auxiliaires qui se trouve dessus une couche (A1) d'arrêt d'attaque.

13. Procédé suivant l'une des revendications 7 à 12,
- dans lequel les couches (M1, M2) métalliques sont en tungstène,
- dans lequel les couches (I1, I2) isolantes sont en SiO₂ ou en nitrure de silicium.
